# EUROPÄISCHE PATENTSCHRIFT

(11) **EP 0 878 880 B1**
(45) Veröffentlichungstag und Bekanntmachung des Hinweises auf die Patenterteilung: **13.12.2000**
(21) Anmeldenummer: 98105826.6
(22) Anmeldetag: 31.03.1998
(51) Int. Cl.: H01S 3/06, H04B 10/105

(54) **Anordnung zum weltraumgestützten Betrieb von als Lichtwellenleiter ausgeführten quantenoptischen Verstärkern**
Apparatus for space based operation of optical waveguide amplifiers
Dispositif pour opération dans l'espace des amplificateurs optiques à guide d'onde

(30) Priorität: 25.06.1997 CH 154097
(43) Veröffentlichungstag der Anmeldung: 18.11.1998
(73) Patentinhaber: Contraves Space AG, 8052 Zürich (CH)
(72) Erfinder: Mayor, Jean-Michel, 1400 Yverdon-les-Bains (CH); Rochat, Etienne, 1400 Yverdon (CH); Haroud, Karim, 1512 Chavannes sur Moudon (CH)
(74) Vertreter: Hotz, Klaus, Dipl.-El.-Ing./ETH

(56) Entgegenhaltungen:
- GB-A- 2 267 006
- JP-A- 63 256 905
- US-A- 5 459 328
- GOLTSOS W C: "Radiation-induced loss studies in Er-doped fiber amplifier systems" FREE-SPACE LASER COMMUNICATION TECHNOLOGIES VIII, SAN JOSE, CA, USA, 30-31 JAN. 1996, Bd. 2699, Seiten 304-309, XP002042503 ISSN 0277-786X, PROCEEDINGS OF THE SPIE - THE INTERNATIONAL SOCIETY FOR OPTICAL ENGINEERING, 1996, SPIE-INT. SOC. OPT. ENG, USA
- GILBERT R M: "Photobleaching of radiation-induced colour centres in a germania-doped glass fibre" IEEE ANNUAL CONFERENCE ON NUCLEAR AND SPACE RADIATION EFFECTS, LAS VEGAS, NV, USA, 20-22 JULY 1982, Bd. ns-29, Nr. 6, Seiten 1484-1488, XP002042458 ISSN 0018-9499, IEEE TRANSACTIONS ON NUCLEAR SCIENCE, DEC. 1982, USA
- MIYAZAKI T ET AL: "A high power Nd-doped double-clad fiber amplifier at 1.06 mu m" FREE-SPACE LASER COMMUNICATION TECHNOLOGIES VIII, SAN JOSE, CA, USA, 30-31 JAN. 1996, Bd. 2699, Seiten 254-265, XP002042504 ISSN 0277-786X, PROCEEDINGS OF THE SPIE - THE INTERNATIONAL SOCIETY FOR OPTICAL ENGINEERING, 1996, SPIE-INT. SOC. OPT. ENG, USA
- DULING III I N ET AL: "SINGLE-POLARISATION FIBRE AMPLIFIER" ELECTRONICS LETTERS, Bd. 28, Nr. 12, Seiten 1126-1128, XP000304631
- S. SHIMIDA, H. ISHIO: "Optical amplifiers and their applications", , JOHN WILEY & SONS, ENGLAND
- T. OKOSHI ET AL.: "New Polarisation-Control Scheme for Optical Heterodyne Receiver using two Faraday Rotators", ELECTRONICS LETTERS, , 29. August 1985, Band 21, Nr. 18, Seiten 787 - 788

## Beschreibung

Die vorliegende Erfindung betrifft eine Anordnung eines als Lichtwellenleiter ausgeführten quantenoptischen Verstärkern unter der Berücksichtigung der im Weltraum anzutreffenden besonderen Bedingungen.

Die bisherige Nutzung von Satelliten für Kommunikations- und Navigationszwecke ist hauptsächlich durch die Verwendung einzelner oder weniger Satelliten geprägt, welche über Mikrowellen-Funkkanäle lediglich mit dem erdgebundenen Betreiber bzw. Nutzer in Verbindung stehen. In Zukunft werden aber vermehrt grössere Gruppen von Satelliten für ein und denselben Zweck in die Erdumlaufbahn gebracht werden wie zum Beispiel die teilweise in der Realisierungsphase befindlichen Kommunikationssysteme auf der Basis von in niedriger Höhe die Erde umlaufenden Satelliten. Deren beschränkte Sichtbarkeit erfordert das permanente Weiterreichen eines erdgebundenen Nutzers zwischen einer Vielzahl kontinuierlich passierender Satelliten.

Die Aufrechterhaltung von Kommunikation über den Sichtbarkeitsbereich eines Satelliten hinaus geschieht durch Informationstransport zwischen den einzelnen Satelliten eines solchen Systems, welche aus Gewichts- und Platzgründen am vorteilhaftesten auf optischem Wege erfolgt. Hierzu sind im Vergleich zur faseroptischen Kommunikation erhebliche optische Leistungen erforderlich, wenngleich diese bezogen auf die für eine Mikrowellenverbindung erforderliche Leistung noch relativ niedrig sind.

Aufgrund der hohen Kohärenz ihrer Lichtemission sind diodengepumpte Festkörperlaser vorteilhaft, sofern besonders energieeffiziente kohärente Übertragungsverfahren zur Anwendung kommen. Die hierbei erforderliche externe Modulation der Phase des vom Laser emittierten Lichts muss bei hoher Modulationsbandbreite mittels eines in Form eines optischen Wellenleiters ausgeführten Modulators vorgenommen werden, welcher nicht mit hohen optischen Leistungen betrieben werden kann. Der Übergang von einem einen kollimierten Strahl emittierenden Festkörperlaser in eine Wellenleiterstruktur gilt als kritisch und verlustbehaftet, wodurch eine zusätzliche Leistungsreserve im nachfolgenden quantenoptischen Verstärker nötig ist. Dessen Ausführung als Festkörperverstärker beinhaltet weitere technische Probleme.

So ist zur hohen Ausnutzung der von Diodenlasern erzeugten optischen Pumpleistung für eine Vielzahl von Durchgängen des zu verstärkenden Lichts durch die optisch gepumpten Zonen des Festkörpers zu sorgen, was zu relativ grossen, massereichen und beschleunigungsempfindlichen Apparaturen führt. Ein mechanisch temperaturstabiler beschleunigungsresistenter Aufbau ist erforderlich, um die Überlappung von Pumplicht- und Signallichtstrahlen gegen äussere Einflüsse zu konservieren.

Die Veröffentlichung von W.C. Goltsos "Radiation-Induced Loss Studies in Er-Doped Fiber Amplifier Systems" Free-Space Laser Communication Technologies VIII, San José, CA, USA, 30 - 31 Jan. 1996, Bd. 2699, Seiten 304 - 309, Proceedings of the SPIE 1996, SPIE-Int. SOC. OPT. Eng., USA, behandelt die Auswirkung von Strahlung auf als Lichtwellenleiter ausgeführte quantenoptische Verstärker, die für den Einsatz im Weltraum ausgelegt sind, und empfiehlt den Verstärker permanent zu betreiben, um strahlungsinduzierte Verfärbungen auszubleichen und somit die Degradation zu verringern. Diese Vorrichtung ist mit Isolatoren versehen, die eine Faraday-Rotation bewirken. Die Auswirkung von Strahlung wird auch behandelt in der Publikation von R. M. Gilbert "Photobleaching of radiation-induced colour centres in a germania-doped glass fiber" IEEE Annual Conference on Nuclear and Space Radiation Effects, Las Vegas, NV, USA, 20.- 22. Juli 1982, Bd. NS-29, Nr. 6, S. 1484 - 1488, IEEE Trans. on Nuclear Science, Dez. 1982, USA.

Zudem ist aus der Veröffentlichung von T.Miyazaki u.a. "A high power Nd-doped double-clad fiber amplifier at 1.06 um", Free-Space Laser Communication Technologies VIII, San José, CA, USA, 30 - 31 Jan. 1996, Bd. 2699, Seiten 254 - 265, Proceedings of the SPIE 1996, an sich bekannt, Pumplicht über das verspiegelte Ende eines Wellenleiters einzukoppeln.

Femer ist in der Mitteilung "New polarisation-control scheme for optical heterodyne receiver using two Faraday rotators" von Okoshi, Cheng und Kikuchi in Electronics Letters, 29.8.1985, Bd. 21, No. 18, S.787-788, eine SOP-Anordnung (state-of-polarisation) mit zwei Faraday Rotatoren und einem akustooptischen Modulator beschrieben.

Schliesslich beschreiben die Patente US-A-5'459'328 und JP-A-63 256 905 verschiedene Einzelheiten in Zusammenhang mit optischen Elementen. Das US-Patent A-5'459'328 betrifft eine mit in Reihe geschalteten lichtemittierenden Dioden bestückte Treiberschaltung, bei der die Kathode einer Photodiode mit dem invertierenden Eingang eines Operationsverstärkers verbunden ist, und das japanische Patent bezieht sich auf eine Vorrichtung zur Drehung der Polarisation einer Faser um ihre Achse mit mechanischen Mitteln, insbesondere mit Hilfe von Platten und Schrauben.

Folglich ist es Aufgabe der im folgenden beschriebenen Erfindung, die bekannten Anordnungen dieser Art zu verbessern.

Diese Aufgabe wird erfindungsgemäss durch eine Anordnung nach Patentanspruch 1 oder 2 gelöst.

Für die Fasern wird ein mit Neodym dotiertes Material verwendet, wodurch wie im als zu verstärkende Quelle verwendeten Neodym-YAG-Festkörperlaser ein Vier-Niveaus-System entsteht, das die Absorption von Signallicht in mangelhaft optisch gepumpten Bereichen des verstärkenden Mediums unterbindet.

Der optisch verstärkende Lichtwellenleiter wird mittels elastischer Bänder an der Wand eines mit Stickstoff gefüllten Gehäuses befestigt, welches wahlweise auch wesentliche elektronische Komponenten wie z. B. Laserdioden zum optischen Pumpen des Verstärkers beinhalten kann.

Die Stickstoff-Füllung dient der Erzeugung erdähnlicher Betriebsbedingungen. So kann, sofern fehlende Konvektion dies gestattet, lokal entstehende Wärme abgeleitet werden und das Ausgasen von Komponenten im Vakuum verhindert werden. Schädliche Ausgasungen werden mittels entsprechender Agenzien gebunden.

Optische Leistung kann in Form kollimierter Strahlen durch aus planparallelen Platten bestehende Quarzglasfenster in das Gehäuse eingestrahlt sowie herausgeführt werden, wahlweise ist dies auch über gasdicht durch die Gehäusewandung geführte Lichtwellenleiter möglich. Sofern planparallele Platten als Fenster vorgesehen sind, welche in besonders leichten Ausführungen durch eine optische Linse ersetzt sind, ist je nach Ausführungsform die Durchstrahlung im Brewsterwinkel zur Elimination von Reflexionen in der verwendeten Polarisationsrichtung vorgesehen. Der verwendete verstärkende Lichtwellenleiter wird unabhängig vom Betriebszustand der gesamten optischen Übertragungseinrichtung ständig von Pumplicht sowie dem aus der Absorption des Pumplichts resultierenden spontan emittierten Licht auf der Wellenlänge des Signallichts oder verstärktem Signallicht durchströmt.
Hierdurch ist eine schnelle Ausheilung von Farbzentren gewährleistet, welche durch die in den Satellitenkörper eindringende Partikelstrahlung verursachte Bremsstrahlung erzeugt werden (Radiation hardening of optical fibre links by photobleaching with light of shorter wavelength, H. Henschel et alt., IEEE Transact. on Nuclear Science, 1996, p. 1050).

Farbzentren erhöhen im allgemeinen die optische Dämpfung von Lichtwellenleitern erheblich. Die Polarisation des den optischen Verstärker verlassenden Lichts wird durch ein mittels Spulen erzeugtes längs der Faserrichtung wirkendes Magnetfeld elektronisch kontrolliert. In einem besonders kompakten Aufbau ist vorgesehen, den verstärkenden Lichtwellenleiter in beiden Ausbreitungsrichtungen zu nutzen, wobei das zu verstärkende Signallicht an einem Ende des Lichtwellenleiters ein seiner dortigen Polarisation um 90 Grad gedreht reflektiert wird und orthogonal polarisiert zurückläuft (Single-polarisation fibre amplifier, I. N. Duling, R. D. Esman, El. Lett., 1992, p. 1126). Eingang und Ausgang des Verstärkers sind am anderen Ende des Lichtwellenleiters durch einen Polarisationsstrahlteiler getrennt. Zur Drehung der Polarisation findet ein in bestimmter Weise in einem oder mehreren überlagerten magnetischen Feldern befindlicher Lichtwellenleiter Verwendung (All-fibre faraday rotator made by a multiturn figure of eight coil with matched birefringence V. Annovazzi-Lodi et alt., IEEE JLT, 1995, p. 2349), der an einem Ende eine reflektierende Schicht aufweist. In diesem Lichtwelleneiter ist in einer besonderen Ausführung der quantenoptische Verstärker integriert. Der Lichtwellenleiter selbst besteht im Querschnitt aus mehreren Schichten, wobei eine Kernschicht nur einen elektrodynamischen Mode des Signallichtes führt, während eine weitere Schicht zusammen mit einer Mantelschicht einen vielmodigen Wellenleiter bildet, in welchem das Pumplicht mit hoher Effizienz eigekoppelt werden kann. Dessen Einkopplung efolgt über kollimierte Strahlen einzelner Laserdioden, die unter Ausnutzung beider orthogonalen Polarisationsrichtungen überlappend, sonst aber nicht überlappend in enger Nachbarschaft zueinander in den mehrmodigen Wellenleiter geführt werden, wodurch störende Überlagerungseffekte weitgehend vermieden werden.

Durch eine grössere Anzahl an Pumplicht generierenden Laserdioden können diese bei reduzierter Leistung mit deutlich erhöhter Lebensdauer betrieben werden, da Partikel- und Bremsstrahlung in den halbleitenden Zone der Laserdioden zusätzliche Ladungsträger freisetzen, die bei normalem Betrieb schädliche Stromdichtespitzen auslösen (Effects of gamma radiation on high-power infrared and visible Laser diodes, M. C. Hastings et alt., IEEE Trans. on nuclear science, 1996, p. 2141). Weiter besteht eine bessere Anpassung der niedrigen Betriebsspannung einer einzelnen Laserdiode an das Bordspannungsniveau des Satelliten, indem diese in Reihe geschaltet werden. Die Regelung der Lichtleistung einzelner Dioden efolgt dabei durch die Regelung eines parallel zur einzelnen Diode fliessenden Kurzschlussstroms. Als Vorteile ergeben sich zum einen das gegenüber einem Festkörper-Verstärker niedrigere Gewicht, die Kompatibilität zu in Wellenleiterform aufgebauten elektrooptischen Modulatoren.

Die vorteilhafte, effiziente Ausnutzung des Pumplichts ist durch die perfekte Überlappung desselben mit dem zu verstärkenden Licht über die sehr lange Strecke des Lichtwellenleiters gewährleistet. Die hohe Ausnutzung des Pumplichts ist zusätzlich durch die hohe Intensität des zu verstärkenden Lichts im Wellenleiter und ein damit hohen Rate stimulierter Emissionen gewährleistet. In einer mit Faraday-Rotator betriebenen Anordnung sind ausserdem noch die Stabilität der Polarisation und die wegen doppelter Ausnutzung des Lichtwellenleiters um etwa die Hälfte kürzere Länge desselben zu nennen. Zusätzlich wird die Inversion beider orthogonaler Polarisationsrichtungen ausgenutzt, was neben einer weiteren Effizienzsteigerung ein verhältnismässig geringes Mass an störender spontaner Emission bewirkt.

Weitere vorteilhafte Ausführungen der Erfindung sind in den abhängigen Ansprüchen angegeben.

Die Erfindung wird nachfolgend beispielsweise an Hand von Zeichnungen näher erläutert. Es zeigen:
- **Fig. 1**: eine Frontansicht eines mit Stickstoff gefüllten Verstärkergehäuses,
- **Fig. 2a**: eine erste Ausführung mit einem geöffneten Verstärkergehäuse,
- **Fig. 2b**: ein zweite Ausführung mit einem geöffneten Verstärkergehäuse,
- **Fig. 2c**: eine dritte Ausführung mit einem geöffneten Verstärkergehäuse,
- **Fig. 3**: eine Ausführung mit einem Faraday-Rotator,
- **Fig. 4**: im Querschnitt Zonen unterschiedlicher Brechzahl eines Lichtwellenleiters,
- **Fig. 5a**: eine Anordnung zur elektronischen Regelung der Polarisation einer sich in einem Lichtwellenleiter fortpflanzenden Lichtwelle,
- **Fig. 5b**: eine Vorrichtung zur Einstellung der Doppelbrechung in Lichtwellenleiterschleifen.
- **Fig. 6**: eine Anordnung zur elektrischen Speisung von pumplichterzeugenden Laserdioden, und
- **Fig. 7**: ein vereinfachtes Schaltbild eines Regelkreises zur Kontrolle der elektrischen Speisung einer Laserdiode.

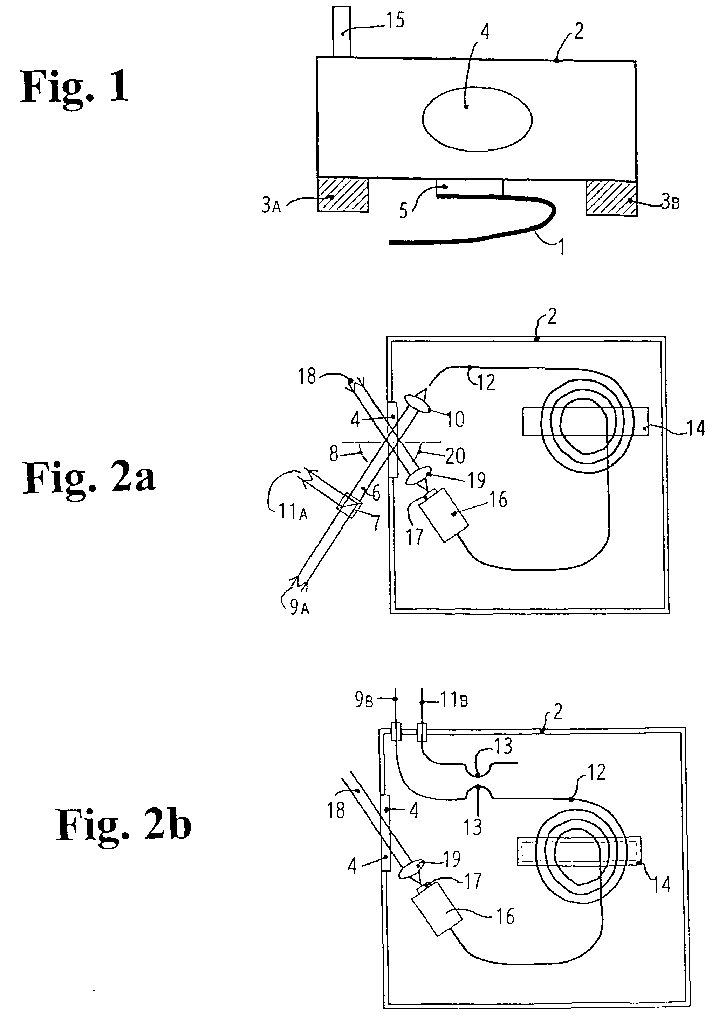

Die in **Fig. 1** gezeigte Frontansicht eines mit Stickstoff gefüllten Verstärkergehäuses **2** besitzt eine Aussparung, in welcher eine planparallele Quarzglasplatte **4** eingefügt ist, durch welche Lichtstrahlen in das Gehäuse ein- und austreten können. Das Verstärkergehäuse **2** ruht auf wärmeisolierenden Stützen **3a**, **3b** und wird durch ein Peltierelement **5** temperaturstabilisiert, dessen nicht mit dem Verstärkergehäuse **2** verbundene Seite mit einem wärmeleitfähigen Band **1** mit einer Wärme- bzw. Kältesenke verbunden ist. Das Verstärkergehäuses **2** wird mit Stickstoff oder einem Gas mit vergleichbar günstigen Eigenschaften gefüllt, um erdähnliche Betriebsbedingungen zu erreichen. Verwiesen sei auf Wärmeabfuhr sowie Ausgasung aus verschiedenen Materialien im Vakuum.

Ein paralleler Betrieb eines im Vakuum befindlichen Verstärkers ist als Langzeitexperiment denkbar, die beschriebene Anordnung besitzt jedoch den Vorteil grösserer Sicherheit angesichts noch nicht reichlich vorhandener Erfahrung mit dem Langzeitbetrieb faseroptischer Elemente im Weltraum. Zur Minimierung der mechanischen Belastung des Verstärkergehäuses **2** kann die Gasfüllung unter der Hälfte des auf dem Erdboden anzutreffenden Drucks erfolgen. Es ist aber auch eine Füllung unter Umgebungsdruck vorgesehen, die während der Aufstiegsphase eines Satelliten über ein Überdruckventil **15** bis auf einen vorher festgelegten Druck abgeblasen wird.

Das in **Fig. 2a** dargestellte zweite Ausführungsbeispiel des geöffneten Verstärkergehäuses **2** verdeutlicht mittels der in ihr gelagerten Komponenten die Funktionsweise der Anordnung. Ein kollimierter Lichtstrahl **9a** aus einem als Lichtquelle dienenden -der Übersichtlichkeithalber nicht dargestellten- Festkörperlaser passiert undeflektiert einen Polarisationsstrahlteiler **7**, um über einen weiteren Ausbreitungsweg **6** durch die Quarzglasplatte **4** hindurch sowie eine erste Linse **10** in einen Lichtwellenleiter **12** gekoppelt zu werden, welcher durch ein elastisches Band **14** am Gehäuseboden fixiert ist. Der Lichtwellenleiter **12** enthält das verstärkende Medium, welches durch ein anderes Ende des Lichtwellenleiters mittels eines Pumplichtstrahls **18** optisch gepumpt wird. Die Einkoppelung des Pumplichtstrahls **18** geschieht über eine zweite Linse **19** durch eine Schicht **17** am Ende des durch eine Vorrichtung **16** gezogenen Lichtwellenleiters **12**, welche für das aus dem Festkörperlaser stammende verstärkte Licht reflektierend, für das Pumplicht hingegen nicht reflektierend wirkt. Die Vorrichtung **16** bewirkt bei zweimaligem Durchgang des zu verstärkenden Lichts eine Drehung der Polarisation um **90** Grad, welche sich auf den bei der Linse **10** liegenden Eingang des Lichtwellenleiters **12** reproduziert, weshalb das verstärkte Licht den Verstärker über den Ausbreitungspfad **6** und den Polarisationsstrahlteiler **7** als deflektierter Strahl **11a** verlässt. Ein Winkel **8** des Ausbreitungspfades **6** zur Oberfläche der Quarzglasplatte **4** kann für den einlaufenden Strahl **9a** den Wert des Brewsterwinkels annehmen, um Reflexionen zu vermeiden. Der Polarisationsstrahlteiler **7** kann auch in Form eines an den Lichtwellenleiter **12** angefügten polarisationsselektiven faseroptischen Kopplers ausgeführt sein, wodurch das direkte Anfügen eines in Wellenleiterform ausgeführten Phasenmodulators ermöglicht wird.

Eine solche Modifikation ist in **Fig. 2b** zu sehen. Durch das Führen der kollimierten Lichtstrahlen **9a** und **11a** (aus **Fig. 2a**) in polarisationserhaltenden Lichtwellenleitern **9b** und **11b** ergibt sich eine weitere Vereinfachung des Aufbaus, zumal ein zur Anwendung kommender polarisationselektiver faseroptischer Koppler **13** leichter und platzsparender auszuführen ist als der Polarisationsstrahlteiler **7**. Der Koppler **13** besteht im wesentlichen aus zwei dicht aneinander geführten stark doppelbrechenden und folglicherweise polarisationserhaltenden Lichtwellenleitern, in welchen in einer bestimmten Polarisationsrichtung geführtes Licht in den jeweils benachbarten Lichtwellenleiter übergekoppelt wird, in der hierzu orthogonalen Polarisationsrichtung hingegen unterbleibt. Der Grund hierzu liegt in im Falle von Kopplung angeglichenen Phasengeschwindigkeiten beider Lichtwellenleiter, welche bei hierzu orthogonaler Polarisation stark zwischen beiden Wellenleitern differieren. So wird entsprechend polarisiertes, im Wellenleiter **9b** in Richtung des Verstärkers transportiertes Licht im Koppler **13** nicht übergekoppelt und in den das verstärkende Medium beinhaltenden Lichtwellenleiter **12** geführt. Die aus der den Lichtwellenleiter **12**, die Vorrrichtung **16** und die Schicht **17** umfassenden Anordnung reflektierte Lichtwelle wird in entgegengesetzter Ausbreitungsrichtung in den Koppler **13** geführt, koppelt aber jetzt in Folge ihrer nunmehr orthogonalen Polarisation auf den wegführenden Lichtwellenleiter **11b** über.

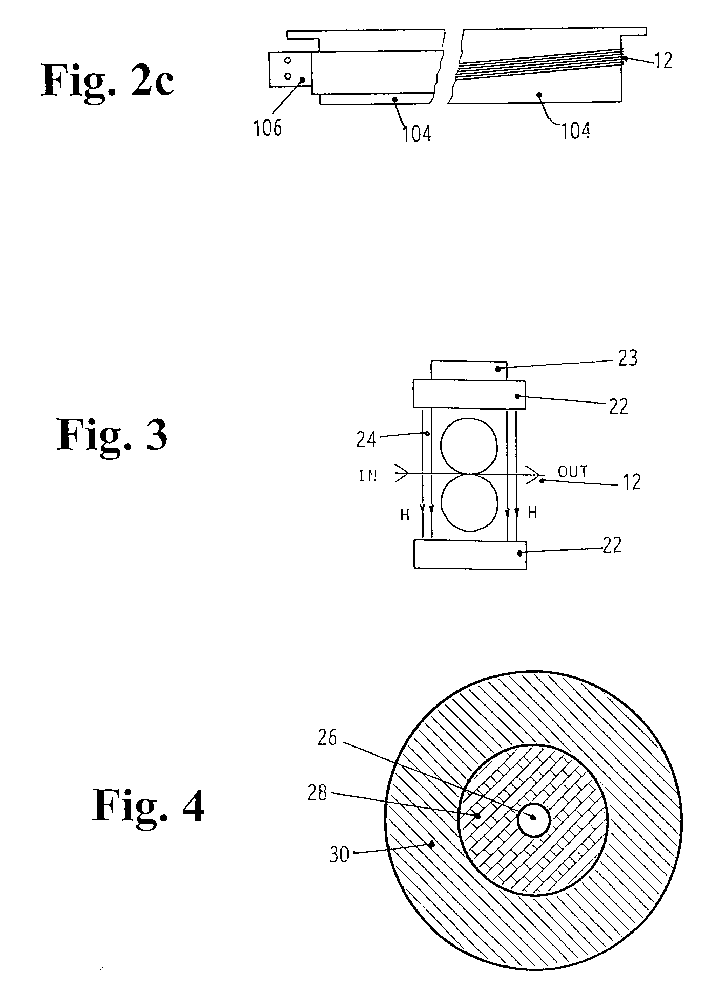

Nach **Fig. 2c** kann der Lichtwellenleiter **12** auch im Vakuum unter thermisch kontrollierbaren homogenen Verhältnissen betrieben werden. Hierzu wird der in ein litzenartiges Geflecht von aus sehr dünnen und wärmeleitfähigen Material bestehenden Fäden eingesponnene Lichtwellenleiter **12** auf einen wärmeleitfähigen Körper **104** gewickelt und mit einer dem Körper **104** in der Form angepassten bandartigen Körper **106** fixiert. Die Temperatur des Körpers **104** kann mit entsprechenden Mitteln geregelt werden. Eine zusätzliche Möglichkeit stellt das Überwickeln des höchstens mit einer dünnen Schutzschicht versehenen, auf einen abgerundeten Körper gewickelten Lichtwellenleiters **12** mit mehreren Lagen dünnen Telflonbandes dar, welches aufgrund seiner Kohäsion ohne Klebemittel aneinanderhaftet.

Die Vorrichtung **16** zur Rotation der Polarisation des zu verstärkenden Lichtes ist in **Fig. 3** dargestellt und besteht im wesentlichen aus einer Anzahl in Achterform ausgeführten Windungen des Lichtwellenleiters **12**, welche sich in der dargestellten Orientierung in einem permanenten zwischen Polen **22** eines Permanentmagneten vorhandenen Magnetfeld **24** befinden. Durch kontrolliertes Einführen von Doppelbrechung und dadurch sich wiederholende Polarisationsdrehungen des durchlaufenden Lichtes in Phase zum im Verhältnis zur Ausbreitungsrichtung wechsellweise auftretenden Magnetfeld **24** erfolgt eine kontinuierliche Farady-Rotation, die pro Durchgang **45** Grad beträgt und sich bei reflektiertem Licht auf **90** Grad addiert. Ein zusätzlicher Elektromagnet **23** dient zum nachträglichen Abgleich der Vorrichtung während der Mission durch Veränderung des Magnetfeldes **24**.

**Fig. 4** zeigt im Querschnitt Zonen unterschiedlicher Brechzahl des in der Anordnung nach **Fig. 2a** zur Anwendung kommenden Lichtwellenleiters **12**, der innerhalb einer kreisrunden Zone **26** die höchste optische Brechzahl aufweist. Diese wird von einer weiteren Zone **28** umschlossen, deren Brechzahl nur unwesentlich niedriger ist, so dass beide Zonen **26** und 28 trotz ihrer relativ hohen Ausdehnung nur einen elektrodynamischen Mode des zu verstärkenden Lichts führen. Eine beide Zonen **28** un **26** umschliessende Zone **30** besitzt eine wesentlich niedrigere optische Brechzahl, so dass zusammen mit den Zonen **26** und **28** ein mehrmodiger Lichtwellenleiter gebildet wird, in welchem das Pumplicht geführt wird. Dieses durchflutet daher die das gewinnerzeugende Medium beinhaltende Zone **26**, welche das zu verstärkende Licht führt.

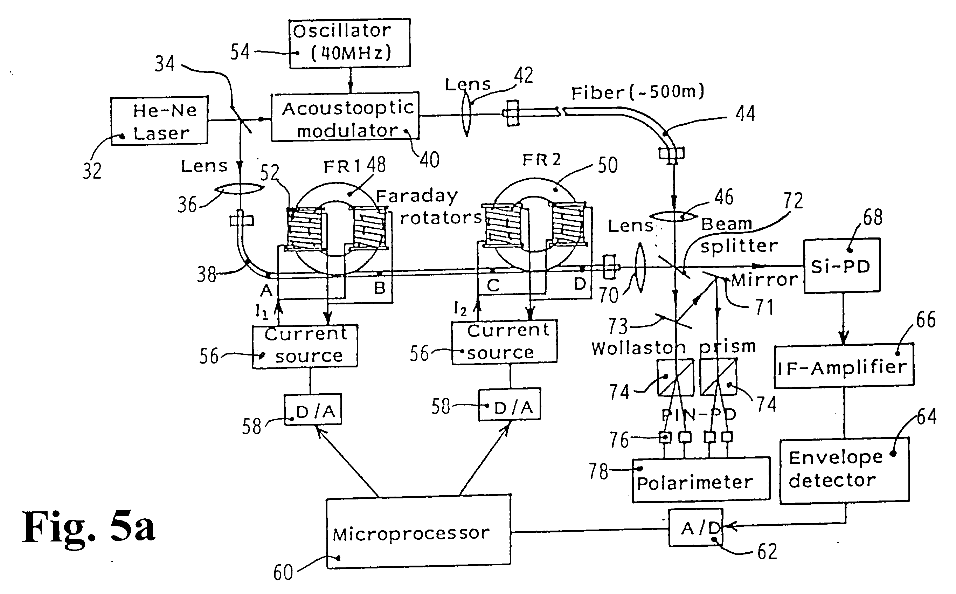

**Fig. 5a** zeigt anhand eines Versuchsaufbaus ein weiteres Prinzip zur Kontrolle der Polarisation einer sich in einem Lichtwellenleiter **38** fortpflanzenden Lichtwelle, die durch einen Laser **32** erzeugt wird. Mittels eines teildurchlässigen Spiegels **34** wird das vom Laser **32** emittierte Licht in zwei Teilstrahlen zerlegt, wobei ein Teil dieses Lichtstrahls durch einen akustooptischen Modulator **40** geleitet wird, wobei dessen optische Frequenz um die Frequenz des Oszillators **54** verschoben wird. Ein zweiter Teil des Lichtstrahls wird in einen Lichtwellenleiter **38** gekoppelt, welcher sich in zwei Spulen **48** und **50** windet, die von elektrischen Spulen **52** umfasst sind. Diese werden über Stromquellen **56** gespeist, wodurch in den Spulen **48** und **50** in Ausbreitungsrichtung der eingekoppelten Lichtwelle ein Magnetfeld entsteht, welches Faraday-Rotation bewirkt. Anschliessend erfolgt nach der Auskopplung aus dem Lichtwellenleiter **38** über eine Linse **70** die Zusammenführung des so entstandenen Lichtstrahls mit dem frequenzverschobenen ersten Teilstrahl, welcher über einen Lichtwellenleiter **44** herangeführt wird, mittels eines teildurchlässigen Spiegels **72**. Beide Teilstrahlen werden in einem Photodetektor **68** miteinander überlagert detektiert, wobei bei identischer Polarisation eine elektrische Welle entsteht, welche die Frequenz des Oszillators **54** besitzt. Nach Passieren eines diese Frequenz bevorzugt verstärkenden Verstärkers 66 und eines Hüllkurvendetektors **64** wird die von diesem erzeugte Gleichspannung in einen Analog-Digital-Wandler geführt, dessen Messwerte einen Mikroprozessor **60** speisen. Dessen Ausgangsdaten beeinflussen über Digital-Analog-Wandler **58** die Sollwerte von die elektrischen Spulen **52** speisenden Stromquellen **56** und damit über das sich ergebende Ausmass der Faraday-Rotation die Polarisation der den Lichtwellenleiter **38** verlassenden Lichtwelle.

Eine Methode zur Manipulation der Polarisation einer sich in beiden zueinander orthogonalen Moden eines Lichtwellenleiters ausbreitenden Lichtwelle ist die Drehung zweier als Ersatz für die bei sich im freien Raum ausbreitenden kollimierten Lichtstrahlen Verwendung findenden Viertelwellenplatten eingesetzten Lichtwellenleiterschlaufen. Hierbei wird die sich bei der Windung des Lichtwellenleiters ergebende stärkere Doppelbrechung des Lichtwellenleiters ausgenutzt, um die Lichtwellen in beiden zueinander orthogonalen Moden in ihrer Phase zueinander um 90 Grad zu verschieben.

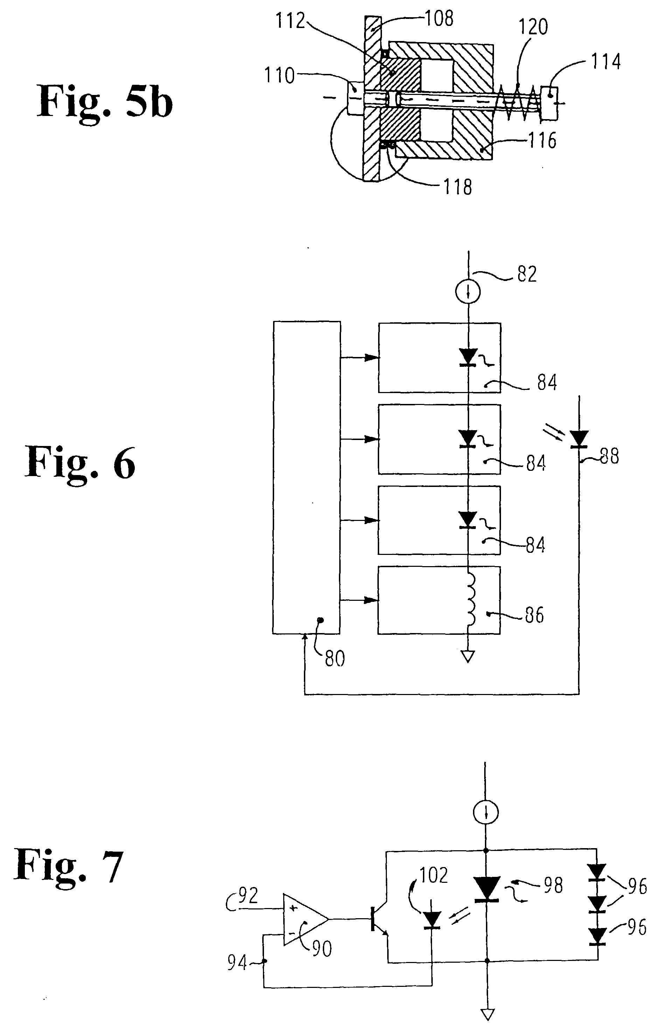

Zur genauen Einstellung oder Kontrolle der Doppelbrechung kann zusätzlich seitlich auf die drehbare Schlaufe Druck ausgeübt werden. **Fig. 5b** zeigt eine hierzu geeignete Vorrichtung. Ein auf einer Grundplatte **108** aufliegender, um einen mittels einer Gewindeschraube **110** auf derselben montierten Zylinder **112** gewundener Lichtwellenleiter **118** wird mittels eines weiteren zylindrischen Körpers **116** mechanischem Druck ausgesetzt, welcher sich aus der zwischen einer weiteren zur Befestigung des Körpers **116** verwendeten Zylinderschraube **114** und dem Körper **116** befindlichen gespannten Spiralfeder **120** ableitet. Es kann natürlich mehr als nur eine Windung des Lichtwellenleiters **118** auf den Körper **112** aufgebracht werden. Statt mit einer Spiralfeder kann der mechanische Druck auch mittels elektromechanischer Mittel erzeugt werden. So ist neben elektromagnetischen Vorrichtungen ein aus piezoelektrischem Material gefertigter Körper **112** vorgesehen, welcher sich durch Anlegen einer elektrischen Spannung in Richtung der Gewindeschraube **114** in seiner Ausdehnung ändert.

**Fig. 6** zeigt ein Blockschaltbild einer Stromversorgung und optischen Leistungskontrolleinheit für die Pumplichtleistung erzeugenden Laserdioden des quantenoptischen Verstärkers. Die Laserdioden sind in Schaltungsblöcke **84** integriert, welche von einem in einer Quelle **82** erzeugten Strom durchflossen werden. Da die benötigte Stromstärke recht hoch, die Betriebsspannung der Blöcke hingegen relativ niedrig ist, erweist sich die Reihenschaltung aller betriebenen oder redundant vorhandenen Schaltungsblöcke **84** in Anpassung an die Satelliten-Bordspannung als die energetisch günstigste Methode. Dies gilt sowohl in Bezug auf die erzeugte Abwärme als auch den zu minimierenden elektrischen Energieverbrauch. Um den Stromfluss durch die einzelnen in den Schaltungsblöcken **84** integrierte Laserdioden trotz des festen von der Quelle **82** ausgehenden Stroms regulieren zu können, wird je nach Bedarf ein Teil des den einzelnen Schaltungsblock **84** durchfliessenden Stroms in diesem um die Laserdiode herumgeleitet. Die Regelung des effektiv durch die einzelnen Laserdioden fliessenden Stroms erfolgt über eine Kontrolleinheit **80**, welche durch eine Photodiode **88** die von allen Laserdiode erzeugte Lichtleistung misst und über in den einzelnen Schaltungsblöcken **84** direkt bei den einzelnen Laserdioden angebrachte Photodioden Daten über die Lichtleistungen der einzelnen Laserdioden erhält. Es ist weiterhin vorgesehen, in einem oder mehreren besagter Schaltungsblöcke die Laserdiode durch die Anschlüsse von für die Polarisationskontrolle vorgesehenen Spulen zu ersetzen, wobei eine oder mehrere Photodioden zusammen mit Polarisationsfiltern den entsprechenden Ist-Wert liefern.

In **Fig. 7** ist der Schaltungsblock **84** in Form eines Reglers dargestellt, d. h., dass in diesem Fall keine Informationen über den Betriebszustand einer Laserdiode **98** in die Kontrolleinheit **80** fliessen. Der Sollwert des durch die Laserdiode **98** erzeugten Photostroms wird in Form einer elektrischen Spannung auf den nichtinvertierenden Eingang **92** eines Operationsverstärkers **90** gegeben, wobei ein invertierender Eingang **94** dieses Operationsverstärkers den Ist-Wert des in einer geeignet beschalteten Photodiode **102** erzeugten Photostroms in Form einer elektrischen Spannung erhält. Der Abgleich von Ist- und Sollwert führt zu einer Ausgangsspannung des Operationsverstärkers **90**, die mittels eines entsprechend beschalteten Transistors **100** in einen hierzu proportionalen die Anschlüsse der Laserdiode **98** überbrückenden Kurzschlussstrom führt. Ein Kurzschluss der Laserdiode **98** bewirkt lediglich ein Hochregeln des durch den Transistor fliessenden Stroms, während ein Ausfall der Leitfähigkeit der Laserdiode **98** ebenfalls wegen des fehelnden Photostroms zu einem Hochregeln des durch den Transistor **100** fliessenden Stroms führt. Ein totaler Ausfall dieser beiden Strompfade wird durch die hierzu parallele Serienschaltung von Halbleiterdioden **96** abgefangen.

## Patentansprüche

1. Anordnung eines als Lichtwellenleiter ausgeführten, im Weltraum betreibbaren quantenoptischen Verstärkers, wobei
- dem verwendeten Lichtwellenleiter (**12**) permanent hinreichend wenigstens soviel Lichtleistung zugeführt wird, dass jeweils die durch Bremsstrahlung entstehenden Farbzentren ausgebleicht werden,
- der Lichtwellenleiter (**12**) vom zu verstärkenden Licht in beiden Richtungen durchlaufen wird,
- ein Ende des Lichtwellenleiters mit einer Schicht (**17**) bedeckt ist, die für das zu verstärkende Licht reflektiv wirkt, Pumplicht (**18**) hingegen reflexionsfrei passieren lässt,
- die Reflexion des zu verstärkenden Lichts von einer mittels Faraday-Rotation bewirkten Polarisationsdrehung um 90 Grad begleitet wird,
- der erforderliche Faraday-Rotator durch Windung des Lichtwellenleiters (**12**) oder durch Führung eines Teils desselben in einem Magnetfeld hergestellt wird,
- die Separierung des in den Verstärker ein- und ausfliesenden zu verstärkenden Lichtes (**9a**, **11a**; **9b**, **11b**) durch einen Polarisationsstrahlteiler (**7**) oder ähnliche geeignete Mittel oder durch einen polarisationsselektiven faseroptischen Koppler (**13**) erfolgt, und
- Mittel zur Einstellung und Kontrolle der Doppelbrechung vorgesehen sind, die eine Grundplatte (**108**) umfassen, auf der ein um einen ersten Zylinder (**112**) gewundener Lichtwellenleiter (**118**) aufliegt, der mittels eines weiteren, den ersten Zylinders umgreifenden zylindrischen Körpers (**116**) mechanischem Druck ausgesetzt wird, wobei mindestens eine Windung des Lichtwellenleiters (**118**) auf dem ersten Zylinder (**112**) vorhanden ist.

2. Anordnung eines als Lichtwellenleiter ausgeführten, im Weltraum betreibbaren quantenoptischen Verstärkers, wobei
- dem verwendeten Lichtwellenleiter (**12**) permanent hinreichend wenigstens soviel Lichtleistung zugeführt wird, dass jeweils die durch Bremsstrahlung entstehenden Farbzentren ausgebleicht werden,
- der Lichtwellenleiter (**12**) vom zu verstärkenden Licht in beiden Richtungen durchlaufen wird,
- ein Ende des Lichtwellenleiters mit einer Schicht (**17**) bedeckt ist, die für das zu verstärkende Licht reflektiv wirkt, Pumplicht (**18**) hingegen reflexionsfrei passieren lässt,
- die Reflexion des zu verstärkenden Lichts von einer mittels Faraday-Rotation bewirkten Polarisationsdrehung um 90 Grad begleitet wird,
- der erforderliche Faraday-Rotator durch Windung des Lichtwellenleiters (**12**) oder durch Führung eines Teils desselben in einem Magnetfeld hergestellt wird,
- die Separierung des in den Verstärker ein- und ausfliesenden zu verstärkenden Lichtes (**9a**, **11a**; **9b**, **11b**) durch einen Polarisationsstrahlteiler (**7**) oder ähnliche geeignete Mittel oder durch einen polarisationsselektiven faseroptischen Koppler (**13**) erfolgt, und
- wobei die Pumplichtleistung erzeugenden Laserdioden des quantenoptischen Verstärkers in Schaltungsblöcke (**84**) integriert sind, welche in Reihe mit einer Konstantstrom-Quelle (**82**) geschaltet sind, wobei um den Stromfluss durch die einzelnen Laserdioden zu regulieren, je nach Bedarf ein Teil des den einzelnen Schaltungsblock (**84**) durchfliessenden Stroms in diesem um die Laserdiode herumgeleitet wird, derart, dass die Regelung des effektiv durch die einzelnen Laserdioden fliessenden Stroms über eine Kontrolleinheit (**80**) und eine mit ihr verbundene Photodiode (**88**) erfolgt, welche die von allen Laserdioden erzeugte Lichtleistung misst.

3. Anordnung nach Anspruch 2, **dadurch gekennzeichnet, dass** Mittel zur Kontrolle der Polarisation einer sich in einem Lichtwellenleiter (**38**) fortpflanzenden Lichtwelle vorhanden sind, derart, dass das Licht in zwei Teilstrahlen zerlegt wird, indem ein Teil dieses Lichtstrahls durch einen Modulator (**40**) geleitet wird, dessen optische Frequenz um die Frequenz eines Oszillators (**54**) verschoben wird, indem ein zweiter Teil des Lichtstrahls in den Lichtwellenleiter (**38**) gekoppelt wird, welcher sich windet und von elektrischen Spulen (**52**) umfasst ist, die über Stromquellen (**56**) gespeist werden, wodurch im Lichtwellenleiter (**38**) in Ausbreitungsrichtung der eingekoppelten Lichtwelle ein Magnetfeld entsteht, welches Faraday-Rotation bewirkt, indem anschliessend nach Auskopplung aus dem Lichtwellenleiter (**38**) eine Zusammenführung des so entstandenen Lichtstrahls mit dem frequenzverschobenen ersten Teilstrahl erfolgt, und indem beide Teilstrahlen in einem Photodetektor (**68**) miteinander überlagert detektiert werden, und indem nach Passieren eines Hüllkurvendetektors (**64**) die von diesem erzeugte Gleichspannung in einen Analog-Digital-Wandler (**62**) geführt wird, dessen Messwerte einen Mikroprozessor (**60**) speisen, dessen Ausgangsdaten die Sollwerte von den die elektrischen Spulen (**52**) speisenden Stromquellen (**56**) und damit über das sich ergebende Ausmass der Faraday-Rotation die Polarisation der den Lichtwellenleiter (**38**) verlassenden Lichtwelle beeinflussen.

4. Anordnung nach Anspruch **3**, **dadurch gekennzeichnet, dass** der Modulator (**40**) ein akustooptischer an einen Oszillator (**54**) angeschlossener Modulator ist.

5. Anordnung nach einem der Ansprüche **2** bis **4**, **dadurch gekennzeichnet, dass** um zu vermeiden, dass Informationen über den Betriebszustand einer Laserdiode (**98**) in die Kontrolleinheit (**80**) fliessen müssen, die Schaltungsblöcke (**84**) jeweils in Form eines Reglers ausgebildet sind, wobei der Sollwert des durch eine Laserdiode (**98**) erzeugten Photostroms in Form einer elektrischen Spannung auf einen nichtinvertierenden Eingang (**92**) eines Operationsverstärkers (**90**) gegeben wird, wobei ein invertierender Eingang (**94**) dieses Operationsverstärkers den Ist-Wert des in einer geeignet beschalteten Photodiode (**102**) erzeugten Photostroms in Form einer elektrischen Spannung erhält, derart, dass der Abgleich von Ist- und Sollwert zu einer Ausgangsspannung des Operationsverstärkers (**90**) führt, die mittels eines entsprechend beschalteten Transistors (**100**) in einen hierzu proportionalen die Anschlüsse der Laserdiode (**98**) überbrückenden Kurzschlussstrom führt.

6. Anordnung nach einem der Ansprüche **3** bis **5**, **dadurch gekennzeichnet, dass** - die Stromquellen (**56**) über Analog/Digital-Wandler (**58**) mit dem Mikroprozessor (**60**) verbunden sind.

7. Anordnung nach einem der Ansprüche **1** bis **6**, dadurch gekennzeichnet, dass - der Lichtwellenleiter (**12**) von einem litzenartigen dünnen Geflecht umsponnen und auf einem wärmeleitfähigen Körper (**104**) aufgewickelt ist.

8. Anordnung nach einem der Ansprüche **1** bis **7**, **dadurch gekennzeichnet, dass** - der Lichtwellenleiter (**12**) mit einer dünnen Schutzschicht, vorzugsweise Teflon, ummantelt und als mehrlagige Wicklung ausgeführt ist.

9. Anordnung nach einem der Ansprüche **1** bis **8**, **dadurch gekennzeichnet, dass**
- der Lichtwellenleiter (**12, 38**, **118**) in einem gasdicht schliessenden Gehäuse (**2**) untergebracht ist, eine Gasfüllung aufweist, die vorzugsweise Stickstoff ist.

10. Anordnung nach Anspruch **9**, **dadurch gekennzeichnet, dass** der Lichtwellenleiter (**12, 38, 118**) in einem gasdicht schliessenden Gehäuse (**2**) untergebracht ist, dessen Gasfüllung einen hälftigen Erdatmosphärendruck aufweist.

## Claims

1. An arrangement comprising a quantum optical amplifier which is constructed as an optical waveguide and which can be operated in space, wherein
- the optical waveguide (**12**) which is used is permanently supplied with an amount of light output which is at least sufficient for each of the colour centres formed by bremsstrahlung to be bleached,
- the light to be amplified travels through the optical waveguide (**12**) in both directions,
- one end of the optical waveguide is covered with a coating (**17**) which acts as a reflector for light to be amplified but which allows pumped light (**18**) to pass through free from reflections,
- the reflection of the light to be amplified is accompanied by a rotation of polarisation by 90 degrees which is effected by means of Faraday rotation,
- the requisite Faraday rotator is produced by winding the optical waveguide (**12**) or by leading a part of the same within a magnetic field,
- separation of the light to be amplified (**9a**, **11a**; **9b**, **11b**) which travels into and out of the amplifier is effected by a polarisation beam splitter (**7**) or similar suitable means or by a polarisation-selective fibre optic coupler (**13**), and
- means are provided for adjusting and controlling birefringence, which comprise a baseplate (**108**) on which an optical waveguide (**118**) rests, which optical waveguide is wound round a first cylinder (**112**) and which is subjected to mechanical pressure by means of a further cylindrical body (**116**) which fits round the first cylinder, wherein at least one winding of the optical waveguide (**118**) is present on the first cylinder (**112**).

2. An arrangement comprising a quantum optical amplifier which is constructed as an optical waveguide and which can be operated in space, wherein
- the optical waveguide (**12**) which is used is permanently supplied with an amount of light output which is at least sufficient for each of the colour centres formed by bremsstrahlung to be bleached,
- the light to be amplified travels through the optical waveguide (**12**) in both directions,
- one end of the optical waveguide is covered with a coating (**17**) which acts as a reflector for light to be amplified but which allows pumped light (**18**) to pass through free from reflections,
- the reflection of the light to be amplified is accompanied by a rotation of polarisation by 90 degrees which is effected by means of Faraday rotation,
- the requisite Faraday rotator is produced by winding the optical waveguide (**12**) or by leading a part of the same within a magnetic field,
- separation of the light to be amplified (**9a**, **11a**; **9b**, **11b**) which travels into and out of the amplifier is effected by a polarisation beam splitter (**7**) or similar suitable means or by a polarisation-selective fibre optic coupler (**13**), and
- wherein the laser diodes of the quantum optical amplifier, which generate the pumped light output, are integrated in circuit blocks (**84**) which are connected in series with a constant current source (**82**), wherein, in order to regulate the current flow through the individual laser diodes, part of the current flowing through the individual circuit block (**84**) is conducted in the latter round the laser diode according to need in such a way that regulation of the current which actually flows through the individual laser diodes is effected via a control unit (**80**) and a photodiode (**88**) connected thereto, which measures the light output generated by all the laser diodes.

3. An arrangement according to claim **2**, **characterised in that** means are present for controlling the polarisation of a light wave propagating in an optical waveguide (**38**) in a manner such that the light is split into two partial beams, by passing one part of said light beam through a modulator (**40**), the optical frequency of which is shifted by the frequency of an oscillator (**54**), by coupling a second part of the light beam into the optical waveguide (**38**) which is wound and is surrounded by electrical coils (**52**) which are supplied via current sources (**56**), whereby a magnetic field which causes Faraday rotation is formed in the optical waveguide (**38**) in the direction of propagation of the coupled-in light wave, by subsequently merging the light beam which is formed in this manner, after it emerges from the optical waveguide (**38**), with the frequency-shifted first partial beam, by detecting both partial beams, which are superimposed on each other, in a photodetector (**68**), and, after passage of the light beam through an envelope detector (**64**), by feeding the DC voltage generated by the latter into an analogue-digital converter (**62**), the data from which are fed to a microprocessor (**60**), the output data of which influence the set values of the current sources (**56**) which supply the electrical coils (**52**) and thus influence the polarisation of the light wave leaving the optical waveguide (**38**) via the resulting magnitude of the Faraday rotation.

4. An arrangement according to claim **3**, **characterised in that** the modulator (**40**) is an acoustooptic modulator connected to an oscillator (**54**).

5. An arrangement according to any one of claims **2** to **4**, **characterised in that** in order to prevent information on the operating state of a laser diode (**98**) from having to flow into the control unit (**80**), the circuit blocks (**84**) are each constructed in the form of a controller, wherein the set value of the photocurrent generated by a laser diode (**98**) is fed in the form of an electrical voltage to a non-inverting input (**92**) of an operational amplifier (**90**), wherein an inverting input (**94**) of said operational amplifier receives the actual value of a photocurrent generated in a suitably connected photodiode (**102**) in the form of an electrical voltage so that the balancing of the actual and set values results in an output voltage of the operational amplifier (**90**), which, by means of an appropriately connected transistor (**100**), results in a short-circuit current which is proportional to said output voltage and which bridges the terminals of the laser diode (**98**).

6. An arrangement according to any one of claims **3** to **5**, characterised in that
- the current sources (**56**) are connected to the microprocessor (**60**) via analogue-digital converters (**58**).

7. An arrangement according to any one of claims **1** to **6**, **characterised in that**
- the optical waveguide (**12**) is covered by thin, plait-like braiding and is wound on a thermally conductive body (**104**).

8. An arrangement according to any one of claims **1** to **7**, **characterised in that**
- the optical waveguide (**12**) is clad with a thin protective layer, preferably of teflon, and is constructed as a multi-layer winding.

9. An arrangement according to any one of claims **1** to **8**, **characterised in that**
- the optical waveguide (**12**, **38**, **118**) is accommodated in a gas-tight, sealed housing (**2**) which has a gas content which is preferably nitrogen.

10. An arrangement according to claim **9**, **characterised in that** the optical waveguide (**12**, **38**, **118**) is accommodated in a gas-tight, sealed housing (**2**), the gas content of which is at half the pressure of the earth's atmosphere.

## Revendications

1. Structure d'un amplificateur à optique quantique pouvant fonctionner dans l'espace et conçu comme un guide d'ondes, telle que
- le guide d'ondes utilisé (**12**) est alimenté en permanence par un flux lumineux au moins suffisant pour que les centres colorés apparaissant par suite du rayonnement de freinage soient blanchis,
- le guide d'ondes (**12**) est parcouru dans les deux sens par la lumière à amplifier,
- une extrémité du guide d'ondes lumineuses est recouverte d'une couche (**17**) qui agit de façon réfléchissante pour la lumière à amplifier et qui, en revanche, laisse passer la lumière de pompage (**18**) sans réflexion,
- la réflexion de la lumière à amplifier s'accompagne d'une rotation de la polarisation à 90 degrés, elle-même réalisée par une rotation de Faraday,
- le rotateur de Faraday nécessaire est fabriqué en incurvant le guide d'ondes lumineuses (**12**) ou en amenant une partie de ce dernier dans un champ magnétique,
- la séparation de la lumière à amplifier entrant dans l'amplificateur et en sortant (**9a**, **11a** ; **9b**, **11b**) se fait à l'aide d'un séparateur de faisceau de polarisation (**7**) ou de moyens appropriés du même type, ou bien à l'aide d'un coupleur à fibre optique à sélection de polarisation (**13**), et
- des moyens d'ajustement et de contrôle de la double réfraction sont prévus, ce qui comprend un support (**108**) sur lequel est appuyé un guide d'ondes (**118**) enroulé autour d'un premier cylindre (**112**), sur lequel est exercée une pression mécanique au moyen d'un autre élément cylindrique (**116**) enveloppant le premier cylindre, le guide d'ondes (**118**) étant au moins enroulé une fois sur le premier cylindre (**112**).

2. Structure d'un amplificateur à optique quantique pouvant fonctionner dans l'espace et conçu comme un guide d'ondes, telle que
- le guide d'ondes utilisé (**12**) est alimenté en permanence par un flux lumineux au moins suffisant pour que les centres colorés apparaissant par suite du rayonnement de freinage soient blanchis,
- le guide d'ondes (**12**) est parcouru dans les deux sens par la lumière à amplifier,
- une extrémité du guide d'ondes lumineuses est recouverte d'une couche (**17**) qui agit de façon réfléchissante pour la lumière à amplifier et qui, en revanche, laisse passer la lumière de pompage (**18**) sans réflexion,
- la réflexion de la lumière à amplifier s'accompagne d'une rotation de la polarisation à 90 degrés, elle-même réalisée par une rotation de Faraday,
- le rotateur de Faraday nécessaire est fabriqué en incurvant le guide d'ondes lumineuses (**12**) ou en amenant une partie de ce dernier dans un champ magnétique,
- la séparation de la lumière à amplifier entrant dans l'amplificateur et en sortant (**9a**, **11a** ; **9b**, **11b**) se fait à l'aide d'un séparateur de faisceau de polarisation (**7**) ou de moyens appropriés du même type, ou bien à l'aide d'un coupleur à fibre optique à sélection de polarisation (**13**), et
- les diodes lasers de l'amplificateur à optique quantique qui produisent la lumière de pompage sont intégrées dans des blocs de connexion (**84**) montés en série avec une source de courant constante (**82**), une partie du courant parcourant chaque bloc de connexion (**84**) étant déviée dans ce dernier autour de la diode laser, afin de réguler le flux de courant passant dans les différentes diodes lasers, de telle sorte que la régulation du courant circulant effectivement à travers les différentes diodes lasers se fait par une unité de contrôle (**80**) et une photodiode (**88**) qui lui est reliée, mesurant le flux lumineux produit par toutes les diodes lasers.

3. Structure selon la revendication **2**, **caractérisée en ce que** sont prévus des moyens de contrôle de la polarisation d'une onde lumineuse se propageant dans un guide d'ondes lumineuses (**38**), de telle façon que la lumière est décomposée en deux faisceaux partiels, une partie de ce faisceau lumineux étant guidée à travers un modulateur (**40**), dont la fréquence optique est décalée de la fréquence d'un oscillateur (**54**), et une deuxième partie du faisceau lumineux étant couplée dans le guide d'ondes lumineuses (**38**), qui est incurvé et entouré de bobines électriques (**52**) alimentées par des sources de courant (**56**), ceci créant dans le guide d'ondes (**38**), dans la direction de propagation de l'onde lumineuse couplée, un champ magnétique, entraînant à son tour une rotation de Faraday, tandis que s'établit ensuite, après découplage hors du guide d'ondes (**38**), une jonction du faisceau lumineux ainsi créé avec le premier faisceau partiel à fréquence décalée, et que les deux faisceaux partiels sont détectés, dans un photodétecteur (**68**), comme superposés l'un à l'autre, et que, après passage d'un détecteur d'enveloppe (**64**), la tension continue produite par celui-ci est amenée dans un convertisseur analogique-numérique (**62**), dont les données de mesure alimentent un microprocesseur (**60**), les données de sortie de ce dernier influant sur les valeurs prescrites des sources de courant (**56**) alimentant les bobines électriques (**52**) et, par conséquent, sur la polarisation de l'onde lumineuse quittant le guide d'ondes (**38**), par suite de la dimension de la rotation de Faraday qui en résulte.

4. Structure selon la revendication **3**, **caractérisée en ce que** le modulateur (**40**) est un modulateur acousto-optique raccordé à un oscillateur (**54**).

5. Structure selon l'une des revendications **2** à **4**, **caractérisée en ce que**, afin d'éviter que des informations concernant l'état de fonctionnement d'une diode laser (**98**) soient obligées de passer dans l'unité de contrôle (**80**), chaque bloc de contrôle (**84**) est conçu sous forme d'un régulateur, la valeur prescrite du courant photoélectrique produit par une diode laser (**98**) étant donnée sur une entrée non inversée (**92**) d'un amplificateur opérationnel (**90**) sous forme d'une tension électrique, tandis qu'une entrée inversée (**94**) de cet amplificateur opérationnel reçoit, sous forme d'une tension électrique, la valeur effective du courant photoélectrique produit dans une photodiode (**102**) disposée de façon appropriée, de telle sorte que l'équilibrage de la valeur effective et de la valeur prescrite conduit à une tension de sortie de l'amplificateur opérationnel (**90**), qui, à l'aide d'un transistor (**100**) disposé de façon adéquate, amène à un courant de court-circuit qui lui est proportionnel, court-circuitant les connexions de la diode laser (**98**).

6. Structure selon l'une des revendications **3** à **5**, **caractérisée en ce que**
- les sources de courant (**56**) sont reliées au microprocesseur (**60**) par un convertisseur analogique-numérique (**58**).

7. Structure selon l'une des revendications **1** à **6**, **caractérisée en ce que**
- le guide d'ondes lumineuses (**12**) est entouré d'un mince entrelacement en forme de torons et est enroulé sur un élément thermoconductible (**104**).

8. Structure selon l'une des revendications **1** à **7**, **caractérisée en ce que**
- le guide d'ondes lumineuses (**12**) est enveloppé par une mince couche de protection, de préférence en Téflon, et est conçu comme une bobine multicouches.

9. Structure selon l'une des revendications **1** à **8**, **caractérisée en ce que**
- le guide d'ondes lumineuses (**12, 38, 118**) est logé dans un boîtier fermé (**2**) étanche au gaz, rempli d'un gaz qui est de préférence de l'azote.

10. Structure selon la revendication **9**, **caractérisée en ce que** le guide d'ondes lumineuses (**12, 38, 118**) est logé dans un boîtier fermé (**2**) étanche au gaz, dont le contenu gazeux présente une pression équivalente à la moitié de la pression atmosphérique terrestre.
